# EUROPEAN PATENT APPLICATION

(11) **EP 4 425 200 A1**
(43) Date of publication of application: **04.09.2024**
(21) Application number: 23160062.8
(22) Date of filing: 03.03.2023
(51) Int. Cl.: G01R 31/367, G01R 31/3828, G01R 31/3842, G01R 31/385, G01R 31/388

(54) **ESTIMATING BATTERY CAPACITY USING INCREMENTAL CAPACITY DIFFERENTIATION**

(71) Applicant: VITO NV, 2400 Mol (BE)
(72) Inventor: SERVOTTE, Jan, 2400 Mol (BE)
(74) Representative: IPLodge bv

(57) **Abstract**

The present invention relates to a system and method for training a model for predicting a capacity of a battery. The method comprises the steps of:
- charging or discharging a training set comprising one or more batterie;
- periodically measuring, during charging or discharging, the voltages and currents of the training set;
- calculating an Incremental Capacity Differentiation (ICD) curve for the batteries of the training set;
- calculating the capacities of the batteries of the training set;
- constructing a model that takes an ICD curve as an input and returns a predicted capacity as an output;
- training the model with the ICD curves and the capacities of the training set.

In addition, the present invention relates to a system and method for predicting a capacity of a battery, using the trained model.

## Description

### Field of the invention

The present invention relates to a system and method for estimating the capacity of a battery.

### Background

In order to operate batteries in a safe and optimal manner, a reliable and cost-effective Battery Management System (BMS) is required. Important functionalities of this BMS are predicting the battery State of Charge (SoC) and State of Health (SoH). The SoC is defined as the ratio of the remaining charge in the battery and the actual capacity of the battery. This parameter is mainly used to estimate the remaining time/mileage before the battery is depleted and requires recharging. The SoH - for which no consensus exists on how it should be determined - is often calculated as the ratio of the actual capacity of the battery and the initial capacity of the battery. The SoH is an important parameter that is used to assess the remaining usefulness of a battery. If the SoH descends to an inferior level, the battery is no longer considered suitable for the application it is used in. Moreover, a decreased SoH could be indicative of imminent cell failure. Early detection of cell failures or ageing characteristics could save time on the replacement or maintenance of battery systems. Estimation of both the SoC and SoH requires estimation of the battery's actual capacity.

A major challenge for the estimation of a battery's actual capacity is the fact that battery capacity degradation is unpredictable and of complex nature due to numerous factors including operational/environmental conditions and inevitable deviations in battery cell manufacturing, which make the problem of capacity estimation a stochastic (non-deterministic) problem. If a number of cells that are produced at the same time, with the same materials and design parameters, are taken as samples, they might not show identical behaviour in capacity degradation. In addition, batteries with different chemical compositions or different microstructures might experience different ageing mechanisms. Therefore, any deterministic approach for the prediction of a battery's capacity is prone to failure.

Patent application publication US 20210311129 A1 discloses the usage of Incremental Capacity Analysis (ICA) for estimating the SoH of a battery. In the ICA technique, a battery is (dis)charged and during said (dis)charging, the battery's current and voltage are periodically measured and registered. Subsequently, the registered current is integrated over time to obtain the stored charge (Q) of the battery as a function of time. Finally, the derivative of Q as a function of time with respect to the battery voltage (V) as a function of time is calculated. The resulting dQ/dV curve, plotted as a function of V, is referred to as the ICA curve. The obtained ICA curve displays characteristic peaks, each of the peaks being indicative of a plateau in the electrochemical potential of one of both electrodes. According to the disclosure of US 20210311129 A1, a machine learning method is trained to identify the correlations between a battery's ICA curve and its SoH. Then, the trained model can be applied to the ICA curve of a battery in order to estimate the battery's SoH.

While US 20210311129 A1 provides for a non-deterministic way to estimate battery SoH (or capacity), there are some problems associated with the usage of ICA. The most common machine learning methods try to identify a correlation between the peaks in the ICA curve and the SoH. However, it is observed that some or all of the peaks of the ICA curve might fade when the battery ages, sometimes disappearing completely. This implies that a proper correlation can be difficult or impossible to establish for aged batteries, thereby increasing the size and extent of the required training data all while decreasing the accuracy of the estimated SoH. In order to counter this problem, the machine learning method can also consider the area under the ICA curve as an input parameter. However, this implies that the ICA curve should be established over a large extent of the battery's SoC window, thereby slowing down the estimation procedure.

Therefore, there is still a need for an alternative and improved method to estimate the actual capacity of a battery.

### Summary

The present invention aims to remedy the above-mentioned and other disadvantages.

According to a first aspect of the invention, a method for training a model for predicting a capacity of a battery is disclosed, the method comprising the steps of:
a) selecting a first temperature range and a first C-rate;
b) charging or discharging a training set comprising one or more batteries at the first C-rate while keeping an environment of the training set within the first temperature range, wherein the charging starts from the one or more batteries of the training set being at a minimum rated voltage and continues until the one or more batteries of the training set are at a maximum rated voltage or the discharging starts from the one or more batteries of the training set being at the maximum rated voltage and continues until the one or more batteries of the training set are at the minimum rated voltage, wherein each of the one or more batteries of the training set are of a substantially equal chemistry;
c) periodically measuring, during the charging or discharging of step (b), a voltage and a current of each of the one or more batteries of the training set;
d) calculating an Incremental Capacity Differentiation (ICD) curve for each of the one or more batteries of the training set, based on the measurements of step (c);
e) calculating the capacity for each of the one or more batteries of the training set, based on the measurements of step (c);
f) selecting a first lower voltage threshold and a first upper voltage threshold;
g) constructing a model that takes an ICD curve as an input and returns a predicted capacity as an output;
h) training the model with the ICD curves, sampled over a training State of Charge (SoC) window between the first lower voltage threshold and the first upper voltage threshold, and the capacities of each of the one or more batteries of the training set.

Throughout this disclosure, the term "battery" generally refers to a battery cell, i.e. a cell comprising a single cathode and a single anode. However, the methods and systems disclosed in this document may also be applied to a battery pack, i.e. the series or parallel connection of multiple battery cells.

Throughout this disclosure, the term "C-rate" has its standard meaning, i.e. the inverse of the time - expressed in hours - that it would take to fully charge or fully discharge the battery at a constant current. The C-rate is thus a measure to normalize a battery's current with respect to the battery's capacity. For instance, for a battery with a capacity of 5 Ah, charging the battery at a C-rate of 1C implies charging the battery with a current of 5 A, whereas for a battery with a capacity of 2 Ah, charging the battery at a C-rate of 1C implies charging the battery with a current of 2 A.

In the context of the present disclosure, the chemistry of the battery refers to the chemical composition of the battery's constituents, the microstructure of the battery refers to the shape and particle size distributions of the constituents of the anode and cathode and the geometry of the battery refers to macroscopically observable geometric parameters of the battery, such as the thickness of anode, cathode and separator, the surface area of the current collectors or the battery's form factor (e.g. pouch, prismatic or cylindrical).

The training set comprises one or more batteries. These batteries are charged or discharged between their minimum rated voltage and their maximum rated voltage at a constant current equal to the first C-rate. The minimum rated voltage and the maximum rated voltage depend on the battery chemistry. Since all the batteries of the training set are of substantially equal chemistry, the minimum rated voltage is equal for all the batteries of the training set and the maximum rated voltage is equal for all the batteries of the training set. When the batteries of the training set are partially charged prior to starting the discharging or charging, the batteries are first charged or discharged to their maximum rated voltage or their minimum rated voltage. This latter charging or discharging may occur at a non-constant current or at a constant current that differs from the first C-rate. Preferably, a rest period is incorporated prior to starting the charging or discharging at the first C-rate to ensure that the battery is in equilibrium.

The environment of the training set is temperature controlled such that its temperature remains within a first temperature range. Preferably, the first temperature range comprises the median or average temperature of the environment in which the batteries would operate outside of a specific test setup. Preferably, the first temperature range is sufficiently narrow such that temperature variations do not significantly impact the behaviour of the batteries. Preferably, the first temperature range does not include temperatures that are so low or so high so as to induce accelerated degradation of the batteries. A suitable first temperature range can be for instance 25 ± 2 °C.

During charging or discharging, the voltage and the current of each of the one or more batteries of the training set are periodically measured and preferably also registered. The employed measurement frequency may be constant or variable. By integrating the measured current over time, the charge Q of each of the one or more batteries can be obtained as a function of time. Since the voltage V of each of the one or more batteries is also known as a function of time, the charge Q of each of the batteries is known as a function of battery voltage V. Thus, if the training set comprises n batteries, the quantities Qᵢ(Vᵢ) are known for i going from 1 to n. If the measurements were taken at k instants in time, each of the quantities Qᵢ(Vᵢ) is a list or vector comprising k values. The charge corresponding to the maximum rated voltage of each of the batteries is the capacity of the battery.

By deriving the battery charge Q with respect to battery voltage V, the Incremental Capacity Analysis (ICA) curve dQ/dV can be obtained. If the training set comprises n batteries, then n ICA curves dQᵢ(Vᵢ)/dVᵢ are known for i going from 1 to n. By deriving the ICA curve again with respect to voltage, the Incremental Capacity Differentiation (ICD) curve d²Q/dV² is obtained. Again, if the training set comprises n batteries, then n ICD curves d²Qᵢ(Vᵢ)/dVᵢ² are known for i going from 1 to n.

A model is constructed that takes a battery's ICD curve as an input and returns a predicted capacity for the battery. Preferably, this model is a non-deterministic model. Preferably, this model is a machine learning model. The model is trained on the ICD curves and capacities that were calculated from the measurements on the training set. Through this training, the model learns to identify a correlation between a battery's ICD curve and said battery's capacity.

Throughout the training of the model, the ICD curves for each of the batteries of the training set are only taken into account between a first lower voltage threshold and a first upper voltage threshold, which do not necessarily - but may - coincide with the minimum and maximum rated voltages of the respective batteries. By training the model only over a training State of Charge (SoC) window that is narrower than the battery's total SoC window, the computational burden of the method is lessened. In addition, future applications of the model may require fewer measurements and/or a shorter measurement time and/or less computational power, as will be further explained in the remainder of this exposure. It should be emphasized that the choice of the first lower voltage threshold and a first upper voltage threshold may emphasize the accuracy of the model. An example of the judicious choice of the first lower and upper voltage threshold will be given in the remainder of this disclosure.

The requirement that all of the batteries of the training set are of substantially equal chemistry is based on the observation that a battery's ICD curve is influenced by the battery's chemistry, microstructure and geometry. However, amongst these three influences, the chemistry of the anode and cathode active materials has the greatest influence on the battery's ICD curve. The chemistry of the electrolyte has less of an influence on the ICD curve. The chemistry of the separator, binder, electronically conductive additives and current collectors has a minor, if not negligible, influence on the ICD curve. Likewise, the microstructure of the anode and cathode active materials has a far smaller influence than the chemistry of the anode and cathode active materials. Finally, the measured currents can be normalized with respect to the battery's geometry.

However, if the chemistry of all the batteries of the training is not substantially equal, the ICD curves of the training set may differ from one another to such a degree that the identified correlation between ICD curve and capacity has a very low accuracy. In this context, substantially equal chemistries must thus be considered as chemistries that yield substantially comparable ICD curves. For instance, while NMC-622 and NMC-532 are different cathode active materials, they do produce comparable ICD curves. In contrast, NMC-532 and LFP are two different cathode active materials that produce non-comparable ICD curves.

It is an advantage of the method that the correlation between a battery's ICD curve and said battery's capacity can be more robust than the correlation between a battery's ICA curve and said battery's capacity, as will be illustrated further in this disclosure.

It is an additional advantage that the identification of a correlation between a battery's ICD curve and said battery's capacity can be of lower mathematical or computational complexity than the correlation between a battery's ICA curve and said battery's capacity, as will be illustrated further in this disclosure.

Both the choice of the first C-rate and the first temperature range may influence the training of the model. In order to ensure the model accuracy in different temperature ranges and/or for different C-rates, the training set may be split into multiple subsets, each subset comprising one or more batteries. The method may then be applied on each training subset with a different combination of first temperature range and first C-rate. For instance, the method may be applied on a first subset for a first temperature range of 20 ± 2 °C and a first C-rate of 1C, on a second subset for a first temperature range of 25 ± 2 °C and a first C-rate of 1C, on a third subset for a first temperature range of 30 ± 2 °C and a first C-rate of C/3. Any combination of first temperature ranges and first C-rate is possible. The skilled person is aware of sensible choices for the first temperature range and the first C-rate.

In some embodiments of the method, step (b) further comprises the sub-step of:
- if the one or more batteries of the training set have been charged to the maximum rated voltage, further charging the one or more batteries of the training set at the maximum rated voltage until the currents of the one or more batteries of the training set decrease below a predetermined threshold value; or
- if the one or more batteries of the training set have been discharged to the minimum rated voltage, further discharging the one or more batteries of the training set at the minimum rated voltage until the currents of the one or more batteries of the training set decrease below a predetermined threshold value.

These embodiments are based on the insight that, depending on the first C-rate, the batteries of the training set may not be fully charged or discharged when they are charged or discharged at a constant current until they attain their respective maximum or minimum rated voltage. This may lead to erroneous capacity measurements - systematically underestimating the capacities of the batteries of the training set - and consequently to a reduced model accuracy. For illustration purposes, at a C-rate of 1C, the capacity of a battery with NMC cathode and Si-C anode may be underestimated by as much as 5-10% if said battery is only charged or discharged by means of a constant current.

As a solution to this problem, a constant voltage charging or discharging step can be implemented once the batteries have attained their respective maximum or minimum rated voltage. During this constant voltage charging/discharging step, the battery current will gradually decrease. Preferably, the charging or discharging of a battery is stopped once the current drops below a predetermined threshold. A reasonable threshold is a current that corresponds to a C-rate of C/20. Do note that - when compared to a charging or discharging cycle during which no constant voltage charging/discharging step takes place - this constant voltage charging/discharging step does not influence the ICD curve (nor the ICA curve) of the battery for the charging or discharging cycle during which the constant voltage charging/discharging step takes place. However, because additional charging/discharging of the battery has taken place, the ICD curve (or the ICA curve) of the battery obtained from the subsequent charging or discharging cycle may look different.

In some embodiments of the method, steps (b) to (e) of the method are repeated for a predetermined number of cycles or until a predetermined criterion is met. Alternatively, steps (b) to (e) of the method are repeated at multiple instances during the lifetime of the batteries of the training set. For instance, steps (b) to (e) may be repeated once a battery of the training set has gone through a fixed number of complete or partial charge and discharge cycles. The model is trained with the ensemble of all ICD curves and capacities obtained during all iterations through steps (b) to (e).

By repeating the steps of charging/discharging multiple times for each of the batteries of the training set, the batteries are actively aged during the method. The steps of charging/discharging the batteries of the training set may be repeated for a predetermined number of cycles or until a predetermined criterion is met. The skilled person is capable of deriving a sensible criterion. Preferably, such a criterion is derived based on the envisaged practical use of the batteries. Alternatively, the batteries of the training set are not actively aged by means of the training method, but the training method is applied at various moments during the lifetime of the batteries of the training set.

In this manner, multiple ICD curves and capacities are available per battery of the training set, each of the ICD curves and capacities obtained during a different moment in the battery's lifetime. The ICD curves and capacities may be calculated during each charge/discharge cycle, or they may be calculated at fixed or varying cycle intervals. It is for instance possible to calculate the battery capacity at every charge discharge cycle and to only calculate a new ICD curve when the capacity has changed by a predetermined amount from the capacity at which the last ICD curve was calculated. For training of the model, it is preferable to only utilize the ICD curve - capacity pairs that were calculated during the same charge/discharge cycles. With an increasing amount of ICD curve - capacity pairs available per battery of the training set, the correlation identified by the model will have increased accuracy over the lifetime of the model. The downside is that the computational requirements of the model also increase with the increasing amount of data. The skilled person is capable of balancing the desired accuracy with the computational requirements of the model.

In some embodiments of the method, each of the one or more batteries of the training set are of a substantially equal microstructure and/or substantially equal geometry.

As previously pointed out, the requirement of these embodiments is based on the observation that a battery's ICD curve is influenced by the battery's chemistry, microstructure and geometry. If each of the one or more batteries of the training set are not only of substantially equal chemistry, but also of substantially equal microstructure and/or substantially equal geometry, the similarity between the ICD curves of these batteries will be greater than if they were of dissimilar microstructure and geometry.

It is an advantage of these embodiments that the size of the training set can be smaller.

It is an additional advantage of these embodiments that the model can identify a stronger correlation between the ICD curve and the capacity.

It is an additional advantage of these embodiments that the model can be of lower mathematical and/or computational complexity.

In some embodiments of the method, training the model comprises identifying a correlation between a magnitude and/or a position of one or more peaks of the ICD curves of the batteries of the training set and the capacities of the batteries of the training set.

It is observed that the maximum amplitude of one or more of the peaks of a battery's ICD curve changes over the lifetime of the battery. Generally, the maximum amplitude of one or more of the peaks decreases as the battery ages. This decrease is not necessarily equal for each concerned peak. Moreover, the maximum amplitude of one or more of the peaks may increase as the battery ages. Again, this increase is not necessarily equal for each concerned peak.

In some embodiments of the method, the first lower voltage threshold and/or the first upper voltage threshold are chosen based on a desired accuracy of the model.

The accuracy of the model - which can be defined as the difference between the capacity predicted by the model for a given cell, based on the ICD curve of said cell, and the actual capacity of the cell - is dependent on the number of peaks in the ICD curve that is taken into account by the model. Under most circumstances, the accuracy of the model increases with the number of peaks that are taken into account. Through a judicious choice of the first lower voltage threshold and/or the first upper voltage threshold, the training SoC window and hence the number of peaks that is taken into account by the model can be chosen.

It is an advantage of these embodiments that a choice can be made between a more restrictive training SoC window that includes fewer peaks - at the cost of reduced model accuracy, but with the benefit of lower model and/or computational complexity - and a more expansive SoC window that includes more peaks - at the cost of increased model and/or computational complexity, but with the benefit of increased model accuracy.

Preferably, the first lower voltage threshold and/or the first upper voltage threshold are chosen such that the training SoC window includes at least one peak.

Preferably, the first lower voltage threshold and/or the first upper voltage threshold are chosen such that the training SoC window is not wider than necessary to include all the peaks displayed by the ICD curve of a specific battery.

In some embodiments of the method, the first lower voltage threshold and/or the first upper voltage threshold are chosen based on the chemistry of the one or more batteries of the training set.

The number of peaks in the ICD curve of a battery, and the location within the battery's SoC window where the peaks are found, is dependent on the battery chemistry, especially on the chemistry of the anode and cathode active materials. It is possible that for a given battery chemistry, a significant number of peaks or even all of the peaks fall within a relatively narrow SoC window. Consequently, the first lower voltage threshold and/or the first upper voltage threshold are preferably chosen such that the SoC window between the first lower voltage threshold and/or the first upper voltage threshold is relatively narrow while still including a significant number of peaks.

It is an advantage of these embodiments that a high model accuracy can be attained while only training the model over a training SoC window that is relatively limited when compared to the battery's total SoC window.

In some embodiments of the method, the first lower voltage threshold corresponds to the minimum rated voltage of the one or more batteries of the training set.

In some embodiments of the method, the model is a Gaussian process regression (GPR) model. Gaussian process regression (GPR) models are nonparametric probabilistic methods that are applied to tackle a broad range of applications such as signal processing, probabilistic inference problems and machine learning. The core assumption of the GPR model is that the correlation that is to be identified follows a Gaussian distribution.

In the context of the present disclosure, there exists a (possibly nonlinear) correlation between the amplitude and/or position of one or more peaks of the ICD curve of a battery cell, at a given moment during the cell's lifetime, and the capacity of the cell at the same moment during the cell's lifetime. The training set thus yields a set of correlations, wherein the number of correlations in the set corresponds to the number of batteries in the training set, multiplied by the number of ICD curve - capacity pairs that were identified during each cell's lifetime. The GPR model assumes that any subset of these correlations is jointly Gaussian. Instead of attempting to identify the individual correlations, the GPR model predicts the Gaussian distribution of the set of correlations.

It is an advantage of these embodiments that a GPR model does not require a large training set.

It is an additional advantage of these embodiments that a GPR model is robust with respect to correlated training data, for instance training data that does not only display a correlation between the ICD curve and the capacity of a cell, but also between the individual peaks of the ICD curve.

According to a second aspect of the invention, a method for predicting a capacity of a battery is disclosed, the method comprising the steps of:
a) selecting a second lower voltage threshold, a second upper voltage threshold, a second C-rate and a C-rate range;
b) charging the battery from the second lower voltage threshold to the second upper voltage threshold at the second C-rate or discharging the battery from the second upper voltage threshold to the second lower voltage threshold at the second C-rate while measuring a temperature of an environment of the battery, wherein the measured temperature defines a second temperature range;
c) periodically measuring, during the charging or discharging of step (b), a voltage and a current of the battery;
d) calculating an Incremental Capacity Differentiation (ICD) curve for the battery over a test State of Charge (SoC) window between the second lower voltage threshold and the second upper voltage threshold, based on the measurements of step (c)
e) selecting a model according to the first aspect of the invention, wherein the chemistry of the batteries of the training set used for training the model is substantially equal to a chemistry of the battery, the second lower voltage threshold is not substantially inferior to the first lower voltage threshold, the second upper voltage threshold is not substantially superior to the first upper voltage threshold, the first temperature range used for training the model overlaps at least partially with the second temperature range and the second C-rate is within the C-rate range of the first C-rate used for training the model;
f) applying the model to the ICD curve to obtain a predicted capacity of the battery.

The battery is partially charged over a test SoC window - from the second lower voltage threshold to the second upper voltage threshold - or partially discharged over the test SoC window - from the second upper voltage threshold to the second lower voltage threshold - at a constant current equal to the second C-rate. Prior to starting this partial discharging or charging, the battery is first charged or discharged to either the second lower voltage threshold or the second upper voltage threshold. This latter charging or discharging may occur at a non-constant current or at a constant current that differs from the second C-rate. Preferably, a rest period is incorporated prior to starting the partial charging or discharging at the second C-rate to ensure that the battery is in equilibrium.

The temperature of the environment of the battery is measured during charging or discharging. The measured values of this temperature define a second temperature range. Alternatively, the environment of the battery may be temperature-controlled in order to keep the temperature within a predetermined second temperature range. During charging or discharging between the second lower voltage threshold to the second upper voltage threshold, the voltage and the current of the battery are periodically measured and preferably also registered. The employed measurement frequency may be constant or variable. By integrating the measured current over time, the charge Q of the battery can be obtained as a function of time. Since the voltage V of the battery is also known as a function of time, the charge Q of the battery is known as a function of battery voltage V.

By deriving the battery charge Q with respect to battery voltage V, the Incremental Capacity Analysis (ICA) curve dQ/dV can be obtained between the second lower voltage threshold and the second upper voltage threshold. By deriving the ICA curve again with respect to voltage, the Incremental Capacity Differentiation (ICD) curve d²Q/dV² is obtained between the second lower voltage threshold and the second upper voltage threshold.

Once the ICD curve of the battery is known, a model according to the first aspect of the invention can be applied to the ICD curve to predict the battery's capacity. When doing so, it is important to ensure that the model that is to be applied has been trained on a training set, the batteries of which are of substantially equal chemistry as the battery under test. If this condition is not met, the correlation between ICD curve and capacity as identified by the model may not apply to the battery. In addition, it is important to ensure that the model has been trained under conditions that are compatible with the conditions under which the ICD curve of the battery has been established.

One of these conditions is that the second lower voltage threshold is not substantially inferior to the first lower voltage threshold used for training the model and that the second upper voltage threshold is not substantially superior to the first upper voltage threshold used for training the model. This condition ensures that the test SoC window is not substantially wider than the training SoC window, such that the ICD curve within the test SoC window does not comprise peaks that have no corresponding counterpart within the training SoC window. If this condition is not met, the model might not be able to use all of the peaks in the recorded ICD curve to predict the battery's capacity.

Preferably, the first lower voltage threshold used for training the model is inferior or equal to the second lower voltage threshold and the first upper voltage threshold used for training the model is superior or equal to the second upper voltage threshold. This ensures that the test SoC window falls entirely within the training SoC window.

Preferably, the first temperature range used for training the model overlaps at least partially with the second temperature range. Preferably, the second temperature range comprises the average temperature of the first temperature range. More preferably, the average temperature of the second temperature range is substantially equal to the average temperature of the first temperature range. Most preferably, the second temperature range is substantially equal to the first temperature range. Due to the influence of temperature on battery performance, the accuracy of the predicted capacity may be lower if the second temperature range does not closely resemble the first temperature range.

Preferably, the second C-rate is within the C-rate range of the first C-rate used for training the model. Preferably, the C-rate range is equal to or smaller than 10% of the first C-rate. For instance, if the first C-rate equals 1C, the second C-rate might then fall in the range (1 ± 0.1)C. Due to the influence of C-rate on the ICD curve - as will be further demonstrated in the remainder of this disclosure - the accuracy of the predicted capacity may be lower if the second C-rate does not closely resemble the first C-rate.

It is an advantage of the method that only a single partial charge or partial discharge over the test SoC window is required to predict the capacity of the battery. The required measurement time to predict the capacity can thus be very short. For instance, at a second C-rate of 1C and a test SoC window corresponding to 25% of the battery's total SoC window, a measurement time of only 15 minutes is required.

It is an additional advantage that the method is of very low computational complexity. Since the model has already been trained, only few calculations are required to predict the battery's capacity. The required calculation time can thus be short and the processor that is to be employed for the calculation can be simple and cheap.

In some embodiments of the method, a microstructure and/or a geometry of the battery are substantially equal to respectively the microstructure and/or the geometry used for training the model.

As previously pointed out, this requirement is based on the observation that a battery's ICD curve is influenced by the battery's chemistry, microstructure and geometry. If the battery under test and the one or more batteries of the training set are not only of substantially equal chemistry, but also of substantially equal microstructure and substantially equal geometry, the correlation between a battery's ICD curve and capacity - as identified by training the model on the training set - will also be more representative of the battery under test.

It is thus an advantage of these embodiments that the accuracy of the predicted capacity is improved.

In some embodiments of the method, the second C-rate is substantially equal to the first C-rate.

It is observed that the ICD curve of a battery is influenced by the C-rate of the charging or discharging during which the underlying voltage and current measurements were acquired. In particular, it is observed that with increasing C-rates, the peaks in the ICD curve become less distinct. This phenomenon occurs because at higher C-rates, the ICD curve is not only determined by the electrochemical potentials of the active materials, but also influenced by charge transport dynamics and reaction overpotentials.

If the battery is tested at the same C-rate that was used to train the model, the correlation between a battery's ICD curve and capacity - as identified by training the model on the training set - will also apply to the battery under test. If, on the other hand, the battery is tested at a different C-rate, the identified correlation does not necessarily apply, which might lead to a reduced accuracy of the predicted capacity.

In some embodiments of the method, if the battery is charged from the second lower voltage threshold to the second upper voltage threshold, the second lower voltage threshold is substantially equal to the first lower voltage threshold; or if the battery is discharged from the second upper voltage threshold to the second lower voltage threshold, the second upper voltage threshold is substantially equal to the first upper voltage threshold.

These embodiments are based on the observation that, especially at higher C-rates, the ICD curve can be dependent on the SoC at which the charging or discharging for the determination of the ICD curve has begun. For instance, if the model has been trained on a data set that was acquired at a C-rate of 2C and with a first lower voltage threshold of 3.2 V and the battery under test is charged at 2C from a second lower voltage threshold of 3.8 V in order to determine its ICD curve, the ICD curves of the training set may not be representative of the ICD curve of the battery under test.

In some embodiments of the method, the second lower voltage threshold and/or the second upper voltage threshold are chosen based on a desired accuracy of the predicted capacity.

In some embodiments of the method, the second lower voltage threshold and/or the second upper voltage threshold are chosen based on the chemistry of the battery.

In some embodiments of the method, the second lower voltage threshold corresponds to a minimum rated voltage of the battery.

The charging of the batteries of the training set always starts from their minimum rated voltage. In addition, as was previously explained, at higher C-rates, the ICD curve may be dependent on the SoC at which the charging or discharging for the determination of the ICD curve has begun. Since the charging for the determination of the ICD curves of the training set begins at the minimum rated voltage, it is preferable if the first lower voltage threshold corresponds to the minimum rated voltage of the batteries of the training set. In addition, it is preferable that the second lower voltage threshold equals the first lower voltage threshold. Finally, since the batteries of the training set and the battery under test are all of substantially equal chemistry, the respective minimum rated voltages of all these batteries likely coincide. Therefore, it is preferable if the second lower voltage threshold corresponds to the minimum rated voltage of the battery in order to improve the accuracy of the model's predictions.

According to a third aspect of the invention, a system for training a model for predicting a capacity of a battery is disclosed, the system comprising:
a) means for charging or discharging a training set comprising one or more batteries at a first C-rate;
b) means for maintaining an environment of the training set within a first temperature range during the charging or discharging of step (a);
c) means for periodically measuring, during the charging or discharging of step (a), a voltage and a current of each of the one or more batteries of the training set;
d) a processor configured to:
   i. receive the measured voltage and measured current of each of the one or more batteries of the training set;
   ii. calculate an Incremental Capacity Differentiation (ICD) curve for each of the one or more batteries of the training set, based on the measured voltage and measured current;
   iii. calculate the capacity for each of the one or more batteries of the training set, based on the measured voltage and measured current;
   iv. construct a model that takes an ICD curve as an input and returns a predicted capacity as an output;
   v. train the model with the ICD curves, sampled over a training State of Charge (SoC) window between the first lower voltage threshold and the first upper voltage threshold, and the capacities of each of the one or more batteries of the training set.

The advantages of the system correspond to the advantage of the method according to the first aspect of the invention.

In some embodiments of the system, the system further comprises means for charging and/or discharging the one or more batteries of the training set at a constant voltage.

According to a fourth aspect of the invention, a system for predicting a capacity of a battery is disclosed, the system comprising:
a) means for charging the battery from a second lower voltage threshold to a second upper voltage threshold at a second C-rate or discharging the battery from the second upper voltage threshold to the second lower voltage threshold at the second C-rate;
b) means for measuring a temperature of an environment of the battery during the charging or discharging of step (a), wherein the measured temperature defines a second temperature range;
c) means for periodically measuring, during the charging or discharging of step (a), a voltage and a current of the battery;
d) a processor configured to:
   i. receive the measured voltage and measured current of the battery;
   ii. calculate an Incremental Capacity Differentiation (ICD) curve for the battery over a test State of Charge (SoC) window between the second lower voltage threshold and the second upper voltage threshold, based on the measured voltage and measured current;
   iii. select a model according to the first aspect of the invention, wherein the chemistry of the batteries of the training set used for training the model is substantially equal to a chemistry of the battery, the second lower voltage threshold is not substantially inferior to the first lower voltage threshold, the second upper voltage threshold is not substantially superior to the first upper voltage threshold, the first temperature range used for training the model overlaps at least partially with the second temperature range and the second C-rate is within a C-rate range of the first C-rate used for training;
   iv. apply the model to the ICD curve to obtain a predicted capacity of the battery.

The advantages of the system correspond to the advantages of the method according to the second aspect of the invention.

In some embodiments, the system also comprises a memory that stores multiple instance of the model according to the first aspect of the invention, wherein each of the instances has been trained with a different combination of first voltage thresholds, first C-rate and first temperature range.

It is an advantage of these embodiments that the test SoC window and second C-rate can be chosen according to circumstances in the environment. For instance, when little time is available, a small test SoC window or a high second C-rate can be selected. Also, the instance of the model that was trained at a first temperature range that overlaps with the second temperature range may be chosen. Alternatively, the system may comprise means for controlling the temperature of the environment of the battery and this temperature may be kept within a predetermined second temperature range. The processor may then select an instance of the trained model, the training conditions of which corresponds closely with the test SoC window, second C-rate and second temperature range.

According to a fifth aspect of the invention, a battery management system is disclosed, the battery management system comprising a system according to the fourth aspect of the invention.

According to a sixth aspect of the invention, a computer program product is disclosed, the computer program product comprising code means to cause a processor, operatively connected to a means for charging and/or discharging one or more batteries and to a means for periodically measuring, during said charging and/or discharging, a voltage and a current of each of the one or more batteries, to carry out the steps of:
a) receiving the measured voltage and measured current of each of the one or more batteries;
b) calculate an Incremental Capacity Differentiation (ICD) curve for each of the one or more batteries, based on the measured voltage and measured current;
c) calculate the capacity for each of the one or more batteries, based on the measured voltage and measured current;
d) construct a model that takes an ICD curve as an input and returns a predicted capacity as an output;
e) train the model with the ICD curves and the capacities of each of the one or more batteries.

According to a seventh aspect of the invention, a computer program product is disclosed, the computer program product comprising code means to cause a processor, operatively connected to a means for charging and/or discharging a battery and to a means for periodically measuring, during said charging and/or discharging, a voltage and a current of the battery, to carry out the steps of:
a) receive the measured voltage and measured current of the battery;
b) calculate an Incremental Capacity Differentiation (ICD) curve for the battery, based on the measured voltage and measured current;
c) select a model according to the first aspect of the invention;
d) apply the model to the ICD curve to obtain a predicted capacity of the battery.

### Brief description of the drawings

Figure 1 (a) shows a graph of battery charge Q as a function of battery voltage V for a battery at two moments during its lifetime.
Figure 1(b) shows an ICA curve, obtained from the data of figure 1(a).
Figure 1(c) shows an ICD curve, obtained from the data of figure 1(a).
Figures 2 (a), (b) and (c) schematically illustrate the selection of the voltage thresholds and related SoC windows.
Figure 3 schematically illustrates an example of a workflow according to the present invention.
Figures 4 (a), (b) and (c) shows measured peak values of ICD curves as a function of battery voltage that were obtained at a C-rate of respectively 1C, C/2 and C/3.
Figures 5 (a) and (b) show respectively the mean absolute error between measured battery capacity and predicted battery capacity and the standard deviation of this mean absolute error as a function of the number of ICD peaks taken into account by the model and of the C-rate employed.
Figures 6 (a) and (b) show the evolution of measured capacity and predicted capacity of two different batteries over time.
Figures 7 (a) and (b) show the mean absolute error between measured battery capacity and predicted battery capacity as a function of the number of ICD peaks taken into account by the model for the same battery at respectively the start of ageing and the end of ageing.

### Detailed description

The present disclosure will be described in terms of specific embodiments, which are illustrative of the disclosure and which are not to be construed as limiting. It will be appreciated that the present disclosure is not limited by what has been particularly shown and/or described and that alternatives or modified embodiments could be developed in the light of the overall teaching of this disclosure. The drawings described are only schematic and are non-limiting.

Reference throughout this description to "one embodiment" or "an embodiment" means that a particular feature, structure or characteristic described in connection with the embodiments is included in one or more embodiment of the present disclosure. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Specific features, structures or characteristics are indicated in the figures by reference numerals. In order not to overload the figures, not every feature is indicated in every figure. Conversely, in order not to overload the text, not every feature indicated in a figure is also discussed in the context of this particular figure.

Finally, the use of ordinal numbers such as "first", "second" and the like throughout this disclosure in no way implies a hierarchical relationship - not in terms of importance, position or time - between the features with which they are used, unless explicitly stated to the contrary. These ordinal numbers serve only to differentiate between different but similar features, properties, or structures.

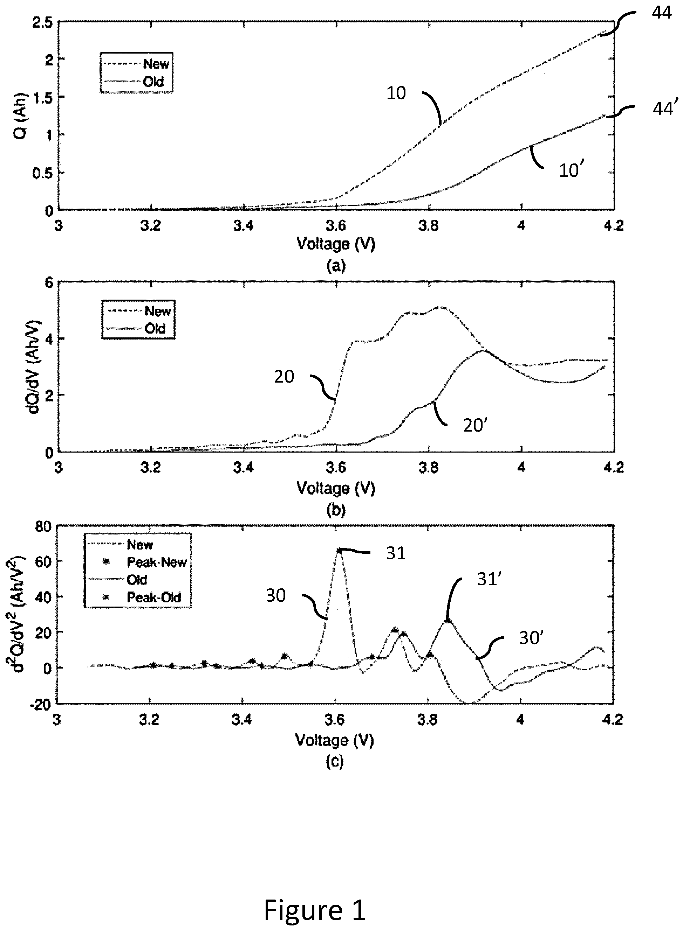

Figure 1(a) shows a graph of battery charge (Q) 10, 10' as a function of battery voltage (V) for a battery at two different moments during the battery's lifetime. The data of figure 1(a) was obtained from a single cell with a NMC cathode, graphite anode and nominal capacity of 3.5 Ah during charging at a constant current of 1C. The total charge stored in the battery at the battery's rated voltage, corresponding to 100% State of Charge (SoC), is referred to as the actual battery capacity 44, 44'. As the battery ages, the charge stored in the battery at a given voltage level declines, and so does the capacity of the battery.

In embodiments of the present invention, a battery's charge Q as a function of the battery's voltage V is obtained by periodically measuring the battery's current and voltage during battery charging and/or discharging. The employed measurement frequency may be constant or variable. The obtained currents and voltages may be filtered or smoothed to remove noise from the measurements. The obtained currents and voltages may be resampled or interpolated, for instance to remove data points from regions with a slow variation of the measured variables or to add interpolated data points in regions with a fast variation of the measured variables. The skilled person is aware of suitable techniques for treating the data. The charge Q is obtained by integrating the measured current over time. Preferably, the charge Q is only calculated after the measurement data has been treated.

Figure 1(b) shows a graph of dQ/dV, the derivative of battery charge Q with respect to battery voltage V, for a battery at two different moments during the battery's lifetime. The curve of dQ/dV as a function of V 20, 20' is employed in the technique of Incremental Capacity Analysis (ICA). Hence, the curve is often referred to as the ICA curve. In the case of figure 1(b), the ICA curves were obtained by differentiating the respective charge curves of figure 1(a) with respect to the battery's voltage. Appropriate numerical differentiation and smoothing techniques can be employed to limit the influence of noise or other artefacts related to the differentiation of discrete measurement data on the obtained ICA curves. Again, the skilled person is aware of suitable techniques for this purpose.

Figure 1(b) highlights two main problems related to the usage of ICA in the prior art. While both ICA curves display multiple local maxima, commonly called peaks, these local maxima fade or downright disappear in the old cell. Therefore, any technique that tries to identify a correlation between the peaks of the ICA curve and battery capacity will suffer a (possibly severe) loss of accuracy when operating over a significant ageing window of the battery. Secondly, the area under the ICA curve is distributed over a significant portion of the battery's operational SoC window. Therefore, any technique that tries to identify a correlation between the area under the ICA curve and battery capacity will need to charge or discharge the battery over a large SoC window which might be very time consuming, especially for cells with large capacities.

Figure 1(c) shows a graph of d²Q/dV², the derivative of the battery's ICA curve with respect to battery voltage V, for a battery at two different moments during the battery's lifetime. The curve of d²Q/dV² as a function of V 30, 30' is employed in the technique of Incremental Capacity Differentiation (ICD). Hence, the curve is referred to as the ICD curve. In the case of figure 1(c), the ICD curves were obtained by differentiating the respective ICA curves of figure 1(b) with respect to the battery's voltage. Again, just like with the ICA curves, appropriate numerical differentiation and smoothing techniques can be employed to limit the influence of noise or other artefacts related to the differentiation of discrete measurement data on the obtained ICD curves. This is even more important for the ICD curves since they concern a second derivative.

Both ICD curves display a number of peaks 31, 31', indicated by star symbols (for the sake of not overloading the figure, not every peak has been labelled with a reference numeral). While the magnitude of the peaks and the position of the peaks as a function of voltage has changed during the lifetime of the battery, both the ICD curve of the cell in "new" condition and of the same cell in "old" condition display an identical number of peaks. This is a common observation when calculating ICD curves and it is exactly this property that makes ICD an interesting alternative to ICA for estimating the capacity of a battery. Since the number of peaks remains constant with ageing of the cell, any technique that tries to identify a correlation between the peaks of the ICD curve and battery capacity could maintain its accuracy over a significant ageing window.

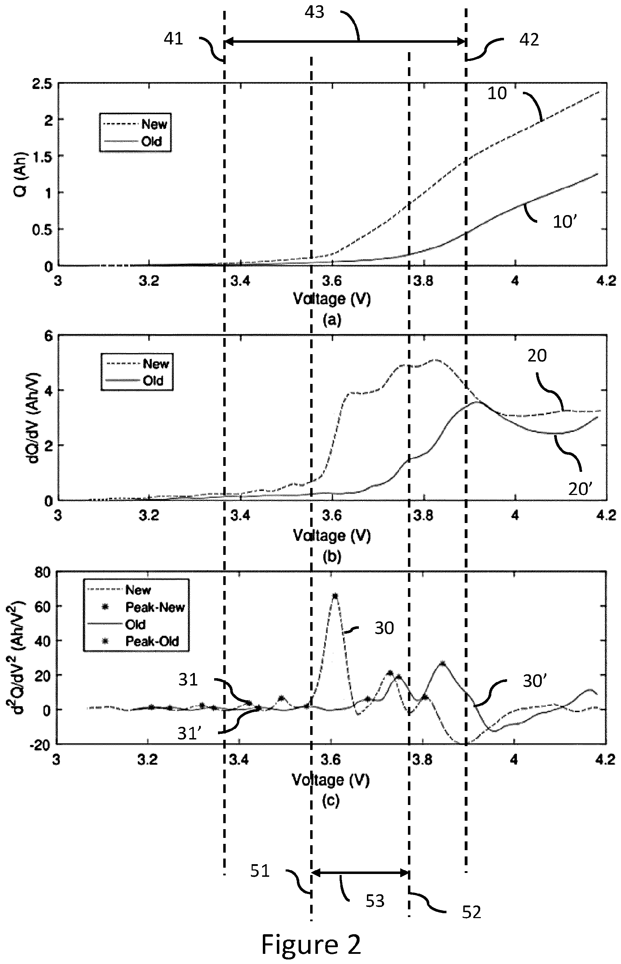

Figures 2(a), 2(b) and 2(c) illustrate the same quantities as figures 1(a), 1(b) and 1(c). However, on figure 2, the first lower voltage threshold 41 and the first upper voltage threshold 42 have been indicated. These two thresholds identify the training SoC window 43 over which the model will be trained.

A more narrow training SoC window generally entails a less complex model and a lower computational load for training the model than a wider training SoC window. However, it is important to ensure that the training SoC window is chosen such that at least one peak of the ICD curves of the training set, and preferably at least one peak of the ICD curve of each battery of the training set, falls within the training SoC window. In the embodiment of figure 2, five peaks fall within the training SoC window. In choosing the training SoC window, it is important to consider that ageing of the battery may cause a shift in the position of the peaks of the ICD curves. In the embodiment of figure 2, the training SoC window is chosen sufficiently wide such that the five corresponding peaks in the ICD curve of the aged battery still fall within the window.

To ensure that these conditions are met, it is preferable to calculate the ICD curves for the batteries of the training set over the entire SoC window, going from full discharge to full charge. Afterwards, the first lower voltage threshold 41 and the first upper voltage threshold 42 can be chosen to ensure that at least one peak of the ICD curves of the training set, and preferably at least one peak of the ICD curve of each battery of the training set, falls within the training SoC window. In addition, when the training set comprises batteries at different states of ageing or when the batteries of the training set have been subject to many charge/discharge cycles during the training method, this approach can ensure that the same number of peaks in the ICD curve of the aged batteries still fall within the window and that those peaks are the corresponding peaks. Afterwards, the model can be trained on the obtained ICD curves within the training SoC window.

On figure 2, the second lower voltage threshold 51 and the second upper voltage threshold 52 have been indicated. These two thresholds identify the test SoC window 53 over which the ICD curve of a battery under test will be constructed. It is important to ensure that the test SoC window is chosen such that at least one peak of the ICD curve of the battery under test falls within the test SoC window. Preferably, the test SoC window 53 falls entirely within the training SoC window 43. This ensures that the model can employ every peak within the test SoC window to predict the capacity of the battery under test.

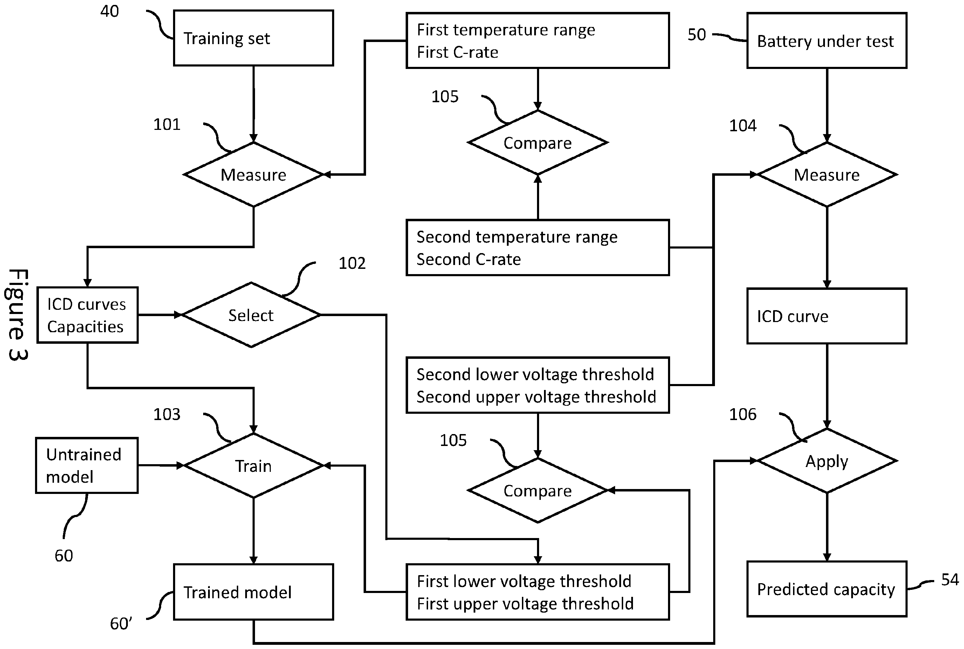

Figure 3 schematically illustrates an example of a workflow according to the present invention. In step 101, the one or more batteries of training set 40 are charged or discharged at the first C-rate while keeping the environment of the training set within the first temperature range. During this charging or discharging, the voltage and the current of each battery of the training set 40 are periodically measured. Based on these measurements, and ICD curve and capacity are calculated for each of the batteries of the training set. Step 101 can be repeated multiple times in order to obtain a the capacities and ICD curves of the batteries of the training set at different moments during their lifetime.

In step 102, the first lower and upper voltage thresholds are selected. The values of these thresholds will determine the training SoC window. Preferably, the obtained ICD curves are taken into account when determining the values. Guidelines and examples for judiciously choosing the thresholds can be found throughout this disclosure.

In step 103, the untrained model 60 is trained on the obtained ICD curves and capacities. During the training step, the model tries to identify a correlation between the ICD curve and the capacity of a battery of the training set, at a given moment during the lifetime of the battery. In order to reduce the computational load of step 102, the model is only trained on the portion of the ICD curves that lies between the first lower voltage threshold and the first upper voltage threshold. The outcome of the step 103 is the trained model 60'.

The battery under test 50, for which the capacity is to be predicted, is generally not a part of the training set. In step 104, the battery under test is charged or discharged between the second lower and upper voltage thresholds. During this charging or discharging, the voltage and the current of battery 50 are periodically measured. Based on these measurements, the ICD curve over the test SoC window is calculated for battery 50. In contrast to the charging and/or discharging of step 101, the charging or discharging of step 104 preferably does not cover the entire SoC window of the concerned battery. Preferably, the charging or discharging of step 104 only occurs once, again in contrast to the charging and/or discharging of step 101.

The skilled person understands that step 104 can also be applied to more than one battery, in this case step 104 will result in an ICD curve between the second lower voltage threshold and second upper voltage threshold for every tested battery. The system used to charge or discharge the battery 50 and to calculate its ICD curve in step 104 is not necessarily the same as the system used to charge and or discharge the batteries of the training set 40 and to calculate their capacities and ICD curves in step 101.

Prior to applying the trained model 60' in order to predict the capacity of the battery under test 50, it must be assessed whether the conditions under which battery 50 was tested are sufficiently close to the conditions under which the model 60' was trained. In step 105, it is checked whether the first lower voltage threshold used for training the model is inferior or equal to the second lower voltage threshold and whether the first upper voltage threshold used for training the model is superior or equal to the second upper voltage threshold. In addition, it is checked whether the first temperature range used for training the model overlaps at least partially with the second temperature range and whether the second C-rate is within the C-rate range of the first C-rate used for training the model. Once these checks have been successfully made, the trained model 60' is applied to the ICD curve of battery 50 to generate the predicted capacity 54 of this battery in step 106.

Generally, the accuracy of the prediction will increase if the second C-rate resembles the first C-rate more closely and if the second temperature range resembles the first temperature range more closely. Preferably, the first temperature range and the first C-rate are known prior to step 104 and the second temperature range and second C-rate are chosen to be substantially equal to the first temperature range and the first C-rate, within the limits of the employed test infrastructure. Alternatively, or in addition, steps 101 and 103 can be carried out for a variety of first temperature ranges and/or first C-rates, wherein each parameter combination can result in a different instance of the trained model 60'. The checking procedure of step 105 may then be used to select the correct instance of the model to be used in step 106.

Embodiments of the present invention were validated on 37 Lithium battery cells of substantially equal chemistry, microstructure and geometry, each cell comprising a NMC cathode, a C-Si anode and having a nominal capacity of 3.5 Ah. In order to generate the results discussed in the remainder of this disclosure, only data obtained during full charging of the cells was used. The first lower voltage threshold was chosen to correspond to 0% SoC. The second lower voltage threshold was chosen equal to the first lower voltage threshold. The first temperature range was chosen as 25 ± 2 °C. The second temperature range was chosen equal to the first temperature range. The first and second C-rate were chosen equal. The peaks of the ICD curve were identified using a moving average filter with an x-axis threshold of 20 mV and a y-axis threshold of 0.1 Ah/V². The skilled person understands that the specific thresholds used for peak finding can be adapted, for instance depending on the battery chemistry. The skilled person also understands that other techniques for peak identification may be employed.

The total number of ICD curves - and corresponding capacities - recorded for training are 425 ICD curves at a charge rate of 1C, 86 ICD curves at a charge rate of C/2 and 84 ICD curves at a charge rate of C/3. The reason for the greater number of experiments at 1C is twofold. First of all, capacity prediction at higher charge rates has more uncertainty and is more challenging than capacity prediction at lower charge rates. Therefore, one might wish to observe the performance of the proposed methods and systems at higher charge rates. Secondly, higher charge rates are more appealing to use in an industrial or commercial setting due to the time saving they offer when compared to lower charge rates.

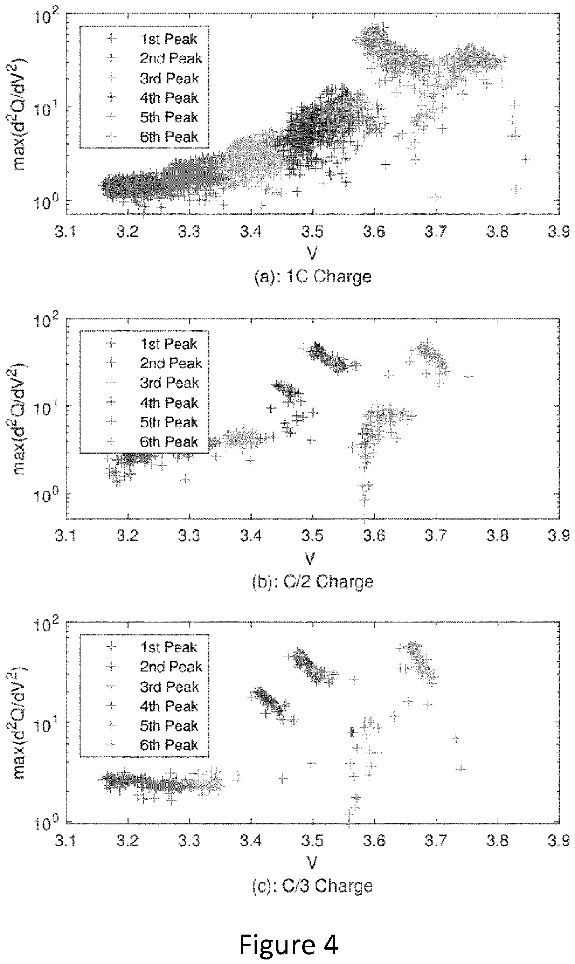

Figure 4 provides a graph of peak amplitude as a function of peak position along the cell's SoC windows for the identified peaks. Figure 4(a) displays the results that were obtained with a constant charging current of 1C, whereas figures 4(b) and 4(c) display the results that were obtained at constant charging currents of respectively C/2 and C/3. Due to the greater number of recorded curves at 1C, figure 4(a) comprises more data points than the others. The employed peak finding algorithm identified six peaks in all of the recorded ICD curves, which illustrates that the peaks of the ICD curve are conserved over the lifetime of a cell, as opposed to the peaks of the ICA curve.

From figure 4, it is immediately apparent that a significant spread exists on both the amplitude and position of the peaks. This spread is caused by two main factors. First of all, there exists an inherent variation between the different cells, even when they are supposed to be of the same chemistry, microstructure and geometry. Secondly, both peak amplitude and peak position might change over the lifetime of a cell. It is also apparent that there are overlaps between both the positions and the amplitudes of the different peaks, leading to possibly highly correlated training data. The inventor has found that, whereas many machine learning algorithms are very sensitive to these correlations within the ICD data, a GPR model is robust with respect to these correlations and is thus especially suitable for application on IDC data.

From figure 4, it is also apparent that at lower C-rates, the spread on both the amplitude and position of the peaks is smaller. This effect occurs because at lower C-rates, the shape of the ICD curve is mainly influenced by the thermodynamics - and thus chemistry - of the battery cell, which leads to clear, distinct peaks in the ICD curve. With increasing C-rate, the effects of reaction kinetics, mass and charge transport become increasingly apparent, leading to peaks in the ICD curve that are less distinct and more spread out.

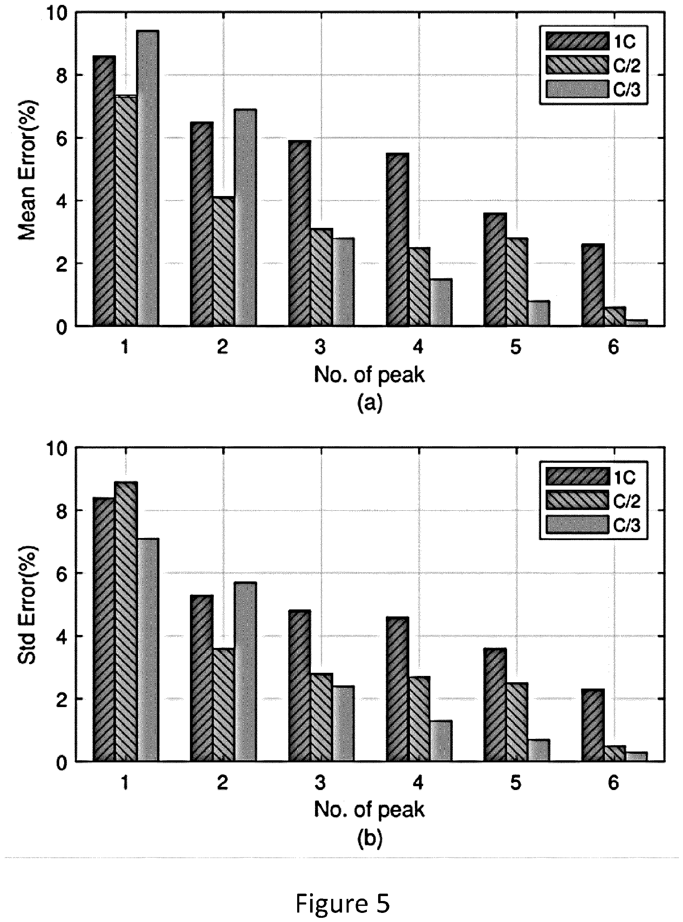

Figure 5 shows the result of a validation experiment wherein the predicted capacity of the 37 battery cells was compared to the measured capacity of the 37 battery cells. Since in this experiment all batteries were part of the training set, the predicted capacities were generated based on the ICD curves of the training set. Hence, this does not concern a "true" validation test of the proposed methodology, as this requires validation on battery cells that do not form part of the training set. Rather, the experiment of figure 5 is intended to show the stochastic behaviour of the model results.

Figure 5(a) shows the mean absolute error (MAE) - the absolute error between predicted and measured capacity, averaged over the number of comparisons - as a function of the constant current C-rate employed for training and testing and the number of peaks taken into account by the model. The MAE is expressed as a percentage of the measured capacity. Figure 5(b) shows the standard deviation (STD) of the absolute errors, again expressed as a percentage of the measured capacity. Two trends can be identified from this data. First of all, both MAE and STD decrease with decreasing C-rate. This occurs because at lower C-rates, the individual peaks are more distinct, as was already mentioned. Secondly, both MAE and STD decrease when an increasing number of peaks of the ICD curve are taken into account. This effect can be explained by the increase in the amount of input data for the model when more peaks are taken into account. Nevertheless, it should be pointed out that even at 1C and with only one peak taken into account - which, for the cells concerned corresponds to a first and second upper voltage threshold of roughly 30% SoC - the model already achieves an accuracy of over 90%. When extending the first and second upper voltage threshold to roughly 50% SoC, all six peaks can be taken into account, resulting in mean accuracies of 99.7%, 99.3% and 97.5% at respective charging rates of C/3, C/2 and 1C.

For peaks 1 and 2, there is an inconsistency in the results in that the MAE and STD for these peaks do not necessarily decrease with decreasing C-rate. This inconsistency arises because of the combined effect of two causes. In first place, the first two peaks have a very small amplitude in NMC/Si-C cells. Secondly, far more experiments are available at a C-rate of 1C than at C/2 and C/3. In case of cells that either have a sufficiently large first peak, or when the number of experiments at every C-rate were to be equal, this inconsistency would not be observed.

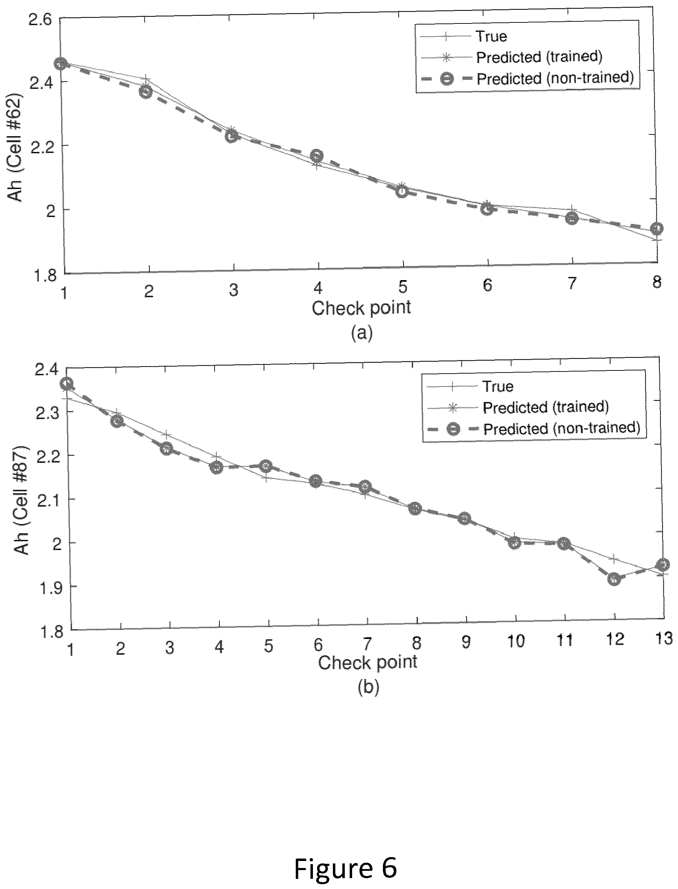

Figure 6 shows the results of a validation experiment wherein the predicted capacity of a battery cell is compared to the measured capacity over the cell's lifetime. Figure 6(a) displays the results for the battery cell labelled as "cell #62", whereas figure 6(b) displays the results for the battery cell labelled as "cell #87". Three different datasets underly figure 6.
- For the first data set, the model was trained on all 37 cells, including cells #62 and #87. Subsequently, the model was used to predict the capacities of cells #62 and #87. These predictions are labelled as "Predicted (trained)" in figure 6.
- For the second data set, the model was trained on 36 cells, including cell #87 but excluding cell #62. Subsequently, the model was used to predict the capacity of cell #62. This prediction is labelled as "Predicted (non-trained) in figure 6(a).
- For the third data set, the model was trained on 36 cells, including cell #62 but excluding cell #87. Subsequently, the model was used to predict the capacity of cell #87. This prediction is labelled as "Predicted (non-trained) in figure 6(b).

All three data sets were generated using a first C-rate and a second C-rate equal to 1C. For the three different data sets, all 6 identified peaks of the ICD curve were used to train the model and to predict the battery capacities. Do note that both "Predicted (non-trained)" data sets concern a proper validation of the proposed methodology and correspond to an embodiment that could be used for battery capacity prediction in an industrial or commercial context.

For cell #62, the ICD curve and capacity were measured along 8 points over the lifetime of the cell, going from a fresh cell (with a measured capacity of 2.46 Ah) at the first measurement point to an aged cell (with a measured capacity of 1.9 Ah) at the last measurement point. Figure 6(a) illustrates that the predicted capacities using both approaches - i.e. one prediction with cell #62 being part of the training set and one prediction with cell #62 not being part of the training set - match one another closely. This result highlights that the output of the trained model is barely impacted by the data of a single cell, thereby indicating that the proposed methodology for capacity prediction is robust. Similarly, figure 6(a) illustrates that at any point during the lifetime of the cell, the absolute value of the error between the predicted capacity and the measured capacity is limited to about 2% of the measured capacity. This indicates that the proposed methodology for capacity prediction is accurate.

Similar data is available for cell #87, for which the ICD curve and capacity were measured along 13 points over the lifetime of the cell, going from a fresh cell (with a measured capacity of 2.34 Ah) at the first measurement point to an aged cell (with a measured capacity of1.90 Ah) at the last measurement point. Figure 6(b) illustrates that the predicted capacities using both approaches - i.e. one prediction with cell #87 being part of the training set and one prediction with cell #87 not being part of the training set - show a near perfect coincidence. This is another confirmation that the proposed methodology is robust. Figure 6(b) also illustrates that at any point during the lifetime of the cell, the absolute value of the error between the predicted capacity and the measured capacity is limited to about 2.5% of the measured capacity. This is another confirmation that the proposed methodology is accurate.

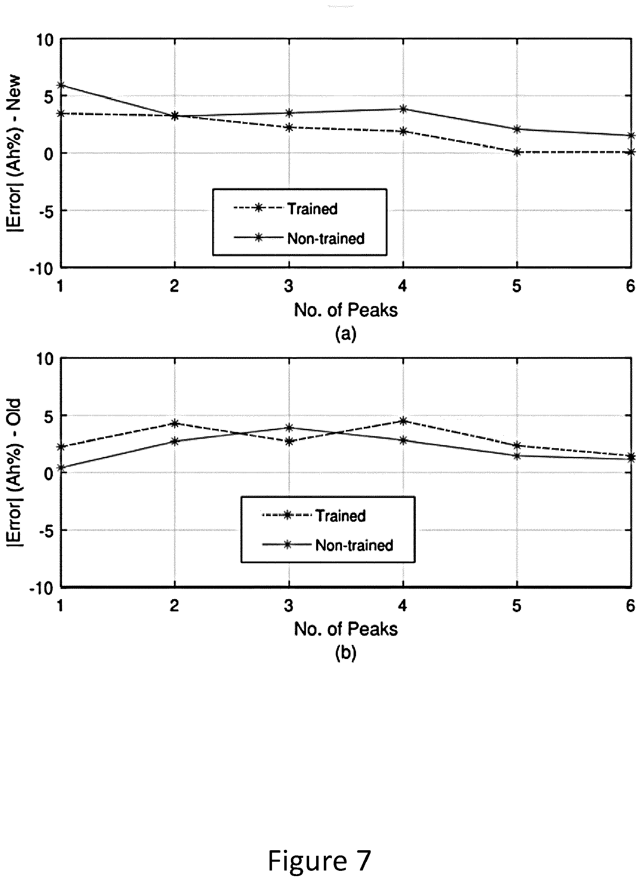

Figure 7 shows the results of a validation experiment wherein the predicted capacity of the battery cell labelled as "cell #62" is compared to the measured capacity of said cell as a function of the number of peaks of the ICD curve that are taken into account by the model. Two different datasets underly figure 7.
- For the first data set, the model was trained on all 37 cells, including cell #62. Subsequently, the model was used to predict the capacity of cell #62. These predictions are labelled as "Predicted (trained)" in figure 7.
- For the second data set, the model was trained on 36 cells, excluding cell #62. Subsequently, the model was used to predict the capacity of cell #62. This prediction is labelled as "Predicted (non-trained) in figure 7.

Figure 7(a) displays the results for the first measurement point in the lifetime of cell #62, as was shown in figure 6(a), whereas figure 7(b) displays the results for the last measurement point in the lifetime of cell #62, as was shown in figure 6(a). On both figures, the absolute value of the prediction error is shown as a percentage of the measured capacity. Do note that the "Predicted (non-trained)" data set concern a proper validation of the proposed methodology and corresponds to an embodiment that could be used for battery capacity prediction in an industrial or commercial context.

In figure 7(a), the prediction error of the "trained" data set is lower than the prediction error of the "non-trained" data set, but both errors remain very similar. In addition, it can be seen that the prediction error decreases when an increasing number of peaks is taken into account, as was already discussed in the context of figure 5. Nevertheless, the prediction error for the "non-trained" data set is only slightly higher than 5% when taking only one peak into account. For instance, this implies that the BMS of a car battery, equipped with a prediction system according to the present invention, could predict the capacity of the car's battery at the beginning of lifetime with an accuracy of roughly 5% after only a very short charging or discharging cycle.

In figure 7(b), the prediction errors of the "trained" and "non-trained" data sets are very similar to one another. In addition, the prediction errors do not display a clear trend as a function of the number of peaks that are taken into account. These somewhat counter-intuitive observations clearly illustrate that battery ageing remains a stochastic phenomenon that is nearly impossible to describe using a deterministic model. Nevertheless, the prediction errors remain inferior to 5%, irrespective of the number of peaks employed and of whether cell #62 was part of the training set or not. This result highlights yet again the robustness and accuracy of the methods and systems of the present invention.

### Reference signs

| | | |
|---|---|---|
| charge Q as function of voltage V | | 10, 10' |
| ICA curve (dQ/dV as function of voltage V) | | 20, 20' |
| ICD curve (d²Q/dV² as function of voltage V) | | 30, 30' |
| peaks of the ICD curve | | 31, 31' |
| training set | | 40 |
| first lower voltage threshold | | 41 |
| first upper voltage threshold | | 42 |
| training SoC window | | 43 |
| calculated (measured) capacity | | 44, 44' |
| battery under test | | 50 |
| second lower voltage threshold | | 51 |
| second upper voltage threshold | | 52 |
| test SoC window | | 53 |
| predicted capacity | | 54 |
| model | | 60, 60' |
| method step comprising: | | 101 |
| | • charging and/or discharging the training set; | |
| | • measuring the voltages and currents of the training set; | |
| | • calculating ICD curves and capacities of the training set | |
| method step comprising: | | 102 |
| | • determining the first lower and upper voltage thresholds | |
| method step comprising: | | 103 |
| | • training a model on the ICD curves and capacities of the training set | |
| method step comprising: | | 104 |
| | • charging or discharging a battery under test | |
| method step comprising: | | 105 |
| | • comparing the first lower voltage threshold to the second lower voltage threshold; | |
| | • comparing the first upper voltage threshold to the second upper voltage threshold; | |
| | • comparing the first C-rate to the second C-rate; | |
| | • comparing the first temperature range to the second temperature range | |
| method step comprising: | | 106 |
| | • applying a trained model to the ICD curve of a battery under test | |

## Claims

1. Method for training a model for predicting a capacity of a battery, the method comprising the steps of:
a. selecting a first temperature range and a first C-rate;
b. charging or discharging a training set comprising one or more batteries at the first C-rate while keeping an environment of the training set within the first temperature range, wherein the charging starts from the one or more batteries of the training set being at a minimum rated voltage and continues until the one or more batteries of the training set are at a maximum rated voltage or the discharging starts from the one or more batteries of the training set being at the maximum rated voltage and continues until the one or more batteries of the training set are at the minimum rated voltage, wherein each of the one or more batteries of the training set are of a substantially equal chemistry;
c. periodically measuring, during the charging or discharging of step (b), a voltage and a current of each of the one or more batteries of the training set;
d. calculating an Incremental Capacity Differentiation (ICD) curve for each of the one or more batteries of the training set, based on the measurements of step (c);
e. calculating the capacity for each of the one or more batteries of the training set, based on the measurements of step (c);
f. selecting a first lower voltage threshold and a first upper voltage threshold;
g. constructing a model that takes an ICD curve as an input and returns a predicted capacity as an output;
h. training the model with the ICD curves, sampled over a training State of Charge (SoC) window between the first lower voltage threshold and the first upper voltage threshold, and the capacities of each of the one or more batteries of the training set.

2. Method according to claim 1, wherein step (b) further comprises the sub-step of:
if the one or more batteries of the training set have been charged to the maximum rated voltage, further charging the one or more batteries of the training set at the maximum rated voltage until the currents of the one or more batteries of the training set decrease below a predetermined threshold value; or
if the one or more batteries of the training set have been discharged to the minimum rated voltage, further discharging the one or more batteries of the training set at the minimum rated voltage until the currents of the one or more batteries of the training set decrease below a predetermined threshold value.

3. Method according to any of the preceding claims, wherein steps (b) to (e) of the method are repeated for a predetermined number of cycles or until a predetermined criterion is met, or wherein steps (b) to (e) of the method are repeated at multiple instants during the lifetime of the batteries of the training set, and wherein the model is trained with the ensemble of all ICD curves and capacities obtained during all iterations through steps (b) to (e).

4. Method according to any of the preceding claims, wherein each of the one or more batteries of the training set are of a substantially equal microstructure and/or substantially equal geometry.

5. Method according to any of the preceding claims, wherein training the model comprises identifying a correlation between a magnitude and/or a position of one or more peaks of the ICD curves of the batteries of the training set and the capacities of the batteries of the training set.

6. Method according to any of the preceding claims, wherein the first lower voltage threshold and/or the first upper voltage threshold are chosen based on a desired accuracy of the model.

7. Method according to any of the preceding claims, wherein the first lower voltage threshold and/or the first upper voltage threshold are chosen based on the chemistry of the one or more batteries of the training set.

8. Method according to any of the preceding claims, wherein the first lower voltage threshold corresponds to the minimum rated voltage of the batteries of the training set.

9. Method according to any of the preceding claims, wherein the model is a Gaussian process regression (GPR) model.

10. Method for predicting a capacity of a battery, the method comprising the steps of:
a. selecting a second lower voltage threshold, a second upper voltage threshold, a second C-rate and a C-rate range;
b. charging the battery from the second lower voltage threshold to the second upper voltage threshold at the second C-rate or discharging the battery from the second upper voltage threshold to the second lower voltage threshold at the second C-rate while measuring a temperature of an environment of the battery, wherein the measured temperature defines a second temperature range;
c. periodically measuring, during the charging or discharging of step (b), a voltage and a current of the battery;
d. calculating an Incremental Capacity Differentiation (ICD) curve for the battery over a test State of Charge (SoC) window between the second lower voltage threshold and the second upper voltage threshold, based on the measurements of step (c)
e. selecting a model according to claim 1, wherein the chemistry of the batteries of the training set used for training the model is substantially equal to a chemistry of the battery, the second lower voltage threshold is not substantially inferior to the first lower voltage threshold, the second upper voltage threshold is not substantially superior to the first upper voltage threshold, the first temperature range used for training the model overlaps at least partially with the second temperature range and the second C-rate is within the C-rate range of the first C-rate used for training the model;
f. applying the model to the ICD curve to obtain a predicted capacity of the battery.

11. Method according to claim 10, wherein a microstructure and/or a geometry of the battery are substantially equal to respectively the microstructure and/or the geometry of the batteries of the training set used for training the model.

12. Method according to claim 10 or 11, wherein the second C-rate is substantially equal to the first C-rate.

13. Method according to any of claims 10 to 12, wherein
if the battery is charged from a second lower voltage threshold to a second upper voltage threshold, the second lower voltage threshold is substantially equal to the first lower voltage threshold; or
if the battery is discharged from a second upper voltage threshold to a second lower voltage threshold, the second upper voltage threshold is substantially equal to the first upper voltage threshold.

14. Method according to any of claims 10 to 13, wherein the second lower voltage threshold and/or the second upper voltage threshold are chosen based on a desired accuracy of the predicted capacity.

15. Method according to any of claims 10 to 14, wherein the second lower voltage threshold and/or the second upper voltage threshold are chosen based on the chemistry of the battery.

16. Method according to any of claims 10 to 15, wherein the second lower voltage threshold corresponds to a minimum rated voltage of the battery.

17. System for training a model for predicting a capacity of a battery, the system comprising:
a. means for charging or discharging a training set comprising one or more batteries at a first C-rate;
b. means for maintaining an environment of the training set within a first temperature range during the charging or discharging of step (a);
c. means for periodically measuring, during the charging or discharging of step (a), a voltage and a current of each of the one or more batteries of the training set;
d. a processor configured to:
i. receive the measured voltage and measured current of each of the one or more batteries of the training set;
ii. calculate an Incremental Capacity Differentiation (ICD) curve for each of the one or more batteries of the training set, based on the measured voltage and measured current;
iii. calculate the capacity for each of the one or more batteries of the training set, based on the measured voltage and measured current;
iv. construct a model that takes an ICD curve as an input and returns a predicted capacity as an output;
v. train the model with the ICD curves, sampled over a training State of Charge (SoC) window between the first lower voltage threshold and the first upper voltage threshold, and the capacities of each of the one or more batteries of the training set.

18. System according to claim 17, the system further comprising means for charging and/or discharging the one or more batteries of the training set at a constant voltage.

19. System for predicting a capacity of a battery, the system comprising:
a. means for charging the battery from a second lower voltage threshold to a second upper voltage threshold at a second C-rate or discharging the battery from the second upper voltage threshold to the second lower voltage threshold at the second C-rate;
b. means for measuring a temperature of an environment of the battery during the charging or discharging of step (a), wherein the measured temperature defines a second temperature range;
c. means for periodically measuring, during the charging or discharging of step (a), a voltage and a current of the battery;
d. a processor configured to:
i. receive the measured voltage and measured current of the battery;
ii. calculate an Incremental Capacity Differentiation (ICD) curve for the battery over a test State of Charge (SoC) window between the second lower voltage threshold and the second upper voltage threshold, based on the measured voltage and measured current;
iii. select a model according to claim 1, wherein the chemistry of the batteries of the training set used for training the model is substantially equal to a chemistry of the battery, the second lower voltage threshold is not substantially inferior to the first lower voltage threshold, the second upper voltage threshold is not substantially superior to the first upper voltage threshold, the first temperature range used for training the model overlaps at least partially with the second temperature range and the second C-rate is within a C-rate range of the first C-rate used for training;
iv. apply the model to the ICD curve to obtain a predicted capacity of the battery.
